# EUROPEAN PATENT APPLICATION

(11) **EP 4 518 624 A1**
(43) Date of publication of application: **05.03.2025**
(21) Application number: 23796805.2
(22) Date of filing: 27.04.2023
(51) Int. Cl.: H10K 50/16, H10K 50/11, H10K 85/60, H10K 85/40

(54) **ORGANIC ELECTROLUMINESCENT ELEMENT**

(30) Priority: 28.04.2022 KR 20220053128
(71) Applicant: Solus Advanced Materials Co., Ltd., Iksan-si, Jeollabuk-do 54584 (KR)
(72) Inventor: HAN, Songie, Yongin-si, Gyeonggi-do 16858 (KR); KIM, Taehyung, Yongin-si, Gyeonggi-do 16858 (KR); SIM, Jaeyi, Yongin-si, Gyeonggi-do 16858 (KR); LEE, Yonghwan, Yongin-si, Gyeonggi-do 16858 (KR); PARK, Woojae, Yongin-si, Gyeonggi-do 16858 (KR); KIM, Jinwoong, Yongin-si, Gyeonggi-do 16858 (KR); MOON, Jonghun, Yongin-si, Gyeonggi-do 16858 (KR); KIM, Youngmo, Yongin-si, Gyeonggi-do 16858 (KR); KIM, Geunhyeong, Yongin-si, Gyeonggi-do 16858 (KR)
(74) Representative: Office Freylinger
(86) International application number: PCT/KR2023/005722
(87) International publication number: WO 2023/211162

(57) **Abstract**

The present invention may provide an organic electroluminescent element that exhibits low driving voltage and high luminous efficiency at the same time by comprising: a first layer, which is at least two electron transport layers, adjacent to a light-emitting layer and composed of a single compound; and a second layer adjacent to a negative electrode and composed of at least two organic compounds.

## Description

### Technical Field

The present disclosure relates to an organic electroluminescent (EL) element including an electron transport layer composed of at least two layers that include a first layer disposed adjacent to an emission layer and consisting of a single compound and a second layer disposed adjacent to a cathode and consisting of at least two organic compounds, whereby the organic electroluminescent (EL) element exhibits improved characteristics such as low driving voltage and high luminous efficiency.

### Background Art

Since 1965, Research on organic electroluminescent (EL) elements (hereinafter referred simply to as "organic EL elements"), which are based on blue electroluminescence using anthracene single crystals, has continued. In 1987, Tang proposed a two-layer stacked structure of organic EL elements composed of a hole transport layer (NPB) and an emission layer (Alq₃). Since then, to achieve the high efficiency and long lifespan necessary for commercialization, a multilayer stacked structure has been proposed, where each layer has distinct and subdivided functions, such as an organic layer for hole injection and transport, an organic layer for electron injection and transport, and an organic layer that induces electroluminescence through the recombination of holes and electrons. The introduction of this multilayer structure has enhanced the performance of organic EL elements to a level suitable for commercialization, beginning with car radio displays in 1997, and has expanded their application to portable information display devices and TV displays.

The demand for larger and higher-resolution displays imposes challenges on the efficiency and lifespan of organic EL elements. In particular, high resolution, achieved by forming more pixels in the same area, results in a reduction in the light-emitting area of the organic EL pixels, thereby reducing their lifespan. This has become one of the most critical technical challenges for organic EL elements.

When current or voltage is applied to an organic EL element across two electrodes, holes are injected into the organic layer from the anode, and electrons are injected into the organic layer from the cathode. When the injected holes and electrons combine, an exciton is formed, and light is emitted as the exciton returns to its ground state. Depending on the type of electron spin in the excitons formed, organic EL elements are classified into fluorescent EL elements, where singlet excitons contribute to light emission, and phosphorescent EL elements, where triplet excitons contribute to light emission.

The electron spin of the excitons formed by the recombination of electrons and holes is generated in a ratio of 25% singlet excitons and 75% triplet excitons. In fluorescent EL elements, where light is emitted by singlet excitons, the internal quantum efficiency theoretically cannot exceed 25%, and the external quantum efficiency is accepted to have a limit of 5%. In phosphorescent EL elements, where light is emitted by triplet excitons, using metal complex compounds containing heavy atoms such as Ir or Pt as phosphorescent dopants can improve luminous efficiency by up to four times compared to fluorescence.

Conventional organic EL elements have used an electron transport layer doped with lithium compounds to facilitate electron injection from the cathode. However, since this electron transport layer contains metal, it is fundamentally prone to oxidation, which can lead to a decrease in the lifespan of the organic electroluminescent element.

### Disclosure of Invention

### Technical Problem

The present disclosure that has been devised to solve the aforementioned problems aims to provide an organic EL element configured to include an electron transport layers including at least two layers composed only of organic compounds, wherein the at least two layers of the electron transport layer includes a first layer composed of a single compound at a region adjacent to an emission layer and a second layer composed of an organic mixture of at least two organic compounds at a region adjacent to a cathode, whereby the EL element exhibits high efficiency, low voltage, and long lifespan.

Other objectives and advantages of the present disclosure will be more clearly explained in the detailed description and claims that follow.

### Solution to Problem

To achieve the aforementioned technical goal, the present disclosure provides an organic electroluminescent element including: an anode; a cathode disposed facing the anode; an emission layer disposed between the anode and cathode; and an electron transport layer disposed between the emission layer and the cathode and provided with at least two layers including a first layer and a second layer, wherein the first layer is adjacent with the emission layer and is composed of a first compound, and the second layer is adjacent to the cathode and is composed of at least two organic compounds including a second compound and a third compound, one of which may be identical to or different from the first compound.

In an embodiment of the present disclosure, the electron transport layer provided with at least two layers does not include any metals and consist of organic materials.

In an embodiment of the present disclosure, the first layer may have a HOMO energy level of 5.4 eV or higher.

In an embodiment of the present disclosure, the first layer may have a bandgap energy of 2.7 eV or higher.

In an embodiment of the present disclosure, the first layer may have a triplet energy of 1.5 eV or higher.

In an embodiment of the present disclosure, the first layer may have a singlet energy of 2.5 eV or higher.

In an embodiment of the present disclosure, the second layer may have a HOMO energy level of 5.6 eV or higher.

In an embodiment of the present disclosure, the second layer may have a bandgap energy of 2.5 eV or higher.

In an embodiment of the present disclosure, the second layer may have a triplet energy of 1.7 eV or higher.

In an embodiment of the present disclosure, the first and second layers may each have a sum of bond moment vectors of 3.336 × 10⁻³¹ C·m or higher.

(The sum of bond moment vectors (D) is obtained from structural optimization calculations based on density functional theory B3LYP/6-31G*) .

In an embodiment of the present disclosure, the second layer may be formed by co-deposition of the second and third compounds.

In an embodiment of the present disclosure, the first to third compounds may be different materials from one another.

In an embodiment of the present disclosure, the sum of bond moment vectors (D₂) in any one of the second and third compounds in the second layer may be larger than the sum of bond moment vectors (D₁) in the first compound.

In an embodiment of the present disclosure, any one of the second and third compounds may be same as the first compound while the other may be a different material from the first compound.

In an embodiment of the present disclosure, the sum of bond moment vectors (D₂) in one of the second and third compounds which differs from the first compound may be larger than the sum of the bond moment vectors (D₁) in the first compound.

In an embodiment of the present disclosure, one of the second and third compounds, which differs from the first compound, is used at a content greater than that of other one that is same as the first compound.

In an embodiment of the present disclosure, the second and third compounds may be mixed at a weight ratio of 50:50 to 90:10, based on the total weight of the second layer.

In an embodiment of the present disclosure, the organic electroluminescent element may include a hole transport region disposed between the anode and the emission layer, wherein the hole transport region may include at least one of a hole injection layer and a hole transport layer.

In an embodiment of the present disclosure, the organic electroluminescent element may include multiple emission layer stacks including at least one emission layer.

### Advantageous Effects of Invention

According to an embodiment of the present disclosure, an electron transport layer is configured to include at least two layers each consisting only of organic compounds, wherein a first layer composed of a single compound is disposed at a region adjacent to an emission layer while a second layer composed of a mixture of at least two organic compounds is arranged at a region adjacent to a cathode, whereby the organic electroluminescent element can achieve low voltage, high efficiency, and long lifespan compared to organic electroluminescent elements with metal-containing electron transport layers.

The advantages of the present disclosure are not limited to the contents exemplified above, and more diverse effects are included in this specification.

### Brief Description of Drawings

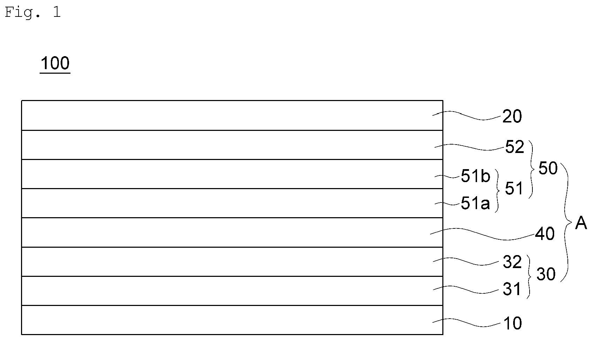

FIG. 1 is a cross-sectional view showing the structure of an organic electroluminescent element according to an embodiment of the present disclosure.

### <Description for Reference Numerals>

100: Organic electroluminescent element
A: Organic layer
10: Anode
20: Cathode
30: Hole transport region
31: Hole injection layer
32: Hole transport layer
40: Emission layer
50: Electron transport region
51: Electron transport layer
51a: First layer
51b: Second layer
52: Electron injection layer

### Best Mode for Carrying out the Invention

Advantages and features of the present disclosure and methods for achieving them will become apparent with reference to the embodiments described below in detail in conjunction with the accompanying drawings. However, the present invention is not limited to the embodiments disclosed below but may be implemented in various different forms, the present embodiments are merely provided to make the disclosure of the present invention complete and to fully convey the scope of the present invention to those of ordinary skill in the art, and the present invention is defined only by the scope of the claims. Thus, in some embodiments, well-known process steps, well-known device structures and well-known techniques are not described in detail in order to avoid obscuring the present disclosure. Like reference numerals refer to like elements throughout the specification.

Unless otherwise defined, all terms used in the present specification (including technical and scientific terms) may be used with meanings that may be commonly understood by those skilled in the art. In addition, the terms defined in the commonly used dictionaries are not ideally or excessively interpreted, unless they are specifically defined clearly.

In addition, throughout the specification, when a part is said to "include" an element, it means that it may further include another element, not excluding other elements, unless otherwise stated. In addition, throughout the specification, "above" or "on" means not only the case where it is located above or below a target part but also the case where there is another part in the middle thereof and does not necessarily mean the upward direction of gravity. As used herein, the terms "first", "second", and the like are used to distinguish elements from each other, rather than indicating any order or importance.

### <Organic Electroluminescent Element>

FIG. 1 is a schematic cross-sectional view showing the structure of an organic electroluminescent element (100) according to the first embodiment of the present disclosure.

Referring to FIG. 1, the organic electroluminescent element (100) in an embodiment of the present disclosure includes: an anode (10); a cathode (20); an emission layer (40) disposed between the anode (10) and the cathode (20); a hole transport region (30) disposed between the anode (10) and the emission layer (40); and an electron transport region (50) disposed between the emission layer (40) and the cathode (20), the electron transport region (50) including an electron transport layer (51) provided with at least two layers where a first layer (51a) is formed of a first compound in a region adjacent to the emission layer (40), and the second layer (51b) is formed of at least two organic compounds in a region adjacent to the cathode (20) .

The preferred embodiments of the organic electroluminescent element according to the present disclosure will be described below with reference to the accompanying drawings. However, the embodiments of the present disclosure can be modified in various other forms, and the scope of the present disclosure is not limited to the embodiments described below.

### Anode

In the organic electroluminescent element (100) according to the present disclosure, the anode (10) serves to inject holes into the organic layer (A).

The material that constitutes the anode (10) is not particularly limited and may be selected from conventional materials known in the industry. Non-limiting examples include: metals such as vanadium, chromium, copper, zinc, and gold; alloys thereof; metal oxides such as zinc oxide, indium oxide, indium tin oxide (ITO), and indium zinc oxide (IZO); combinations of metals and oxides such as ZnO:Al, SnO₂:Sb, etc.; conductive polymers such as polythiophene, poly(3-methylthiophene), poly[3,4-(ethylene-1,2-dioxy)thiophene] (PEDT), polypyrrole, polyaniline, etc.; and carbon black.

The method of manufacturing the anode (10) is also not particularly limited and can be carried out using conventional methods known in the industry. An example of the method includes coating the anode material onto a substrate made of a silicon wafer, quartz, glass plate, metal plate, or plastic film.

### Cathode

In the organic electroluminescent element (100) according to the present disclosure, the cathode (20) serves to inject electrons into the organic layer (A).

The material that constitutes the cathode (20) is not particularly limited and may be selected from conventional materials known in the industry. Non-limiting examples include: metals such as magnesium, calcium, sodium, potassium, titanium, indium, yttrium, lithium, gadolinium, aluminum, silver, tin, lead, etc.; alloys thereof; and multilayer materials such as LiF/Al, LiO₂/Al, etc.

The method of manufacturing the cathode (20) is also not particularly limited and can be carried out using methods known in the industry.

### Organic Layer

The organic layer (A) included in the organic electroluminescent element according to the present disclosure may employ conventional configuration used for organic layers in existing organic EL elements without limitation. For example, the organic layer may include one or more selected from the group consisting of a hole transport region (30), an emission layer (40), and an electron transport region (50). Considering the characteristics of the organic electroluminescent element, it is preferable to include all of the aforementioned organic layers.

### Hole Transport Region

The hole transport region (30) included in the organic layer (A) of the present disclosure serves to transport holes injected from the anode (10) to the emission layer (40). This hole transport region (30) may include at least one selected from the group consisting of a hole injection layer (31) and a hole transport layer (32). In view of the characteristics of the organic electroluminescent element, it is preferable to include both the hole injection layer (31) and the hole transport layer (32).

No particular limitations are imparted to the material constituting the hole injection layer (31) and the hole transport layer (32) as long as it has a low hole injection barrier and high hole mobility. Any hole injection/transport material used in the industry may be used without limitation. In this regard, the materials constituting the hole injection layer (31) and the hole transport layer (32) may be same or different.

The hole injection materials may be selected from any known hole injection materials without limitation. Non-limiting examples of hole injection materials include: phthalocyanine compounds such as copper phthalocyanine; N,N'-diphenyl-N,N'-bis-[4-(phenyl-m-tolyl-amino)-phenyl]-biphenyl-4,4'-diamine (DNTPD); 4,4',4"-tris(3-methylphenylphenylamino) triphenylamine (m-MTDATA); 4,4',4"-tris(N,N-diphenylamino)triphenylamine (TDATA); 4,4',4"-tris{N,**-**(2-naphthyl)-N-phenylamino}-triphenylamine (2TNATA); poly(3,4-ethylenedioxythiophene)/poly(4-styrenesulfonate) (PEDOT/PSS); polyaniline/dodecylbenzenesulfonic acid (PANI/DBSA); polyaniline/camphor sulfonic acid (PANI/CSA); and polyaniline/poly(4-styrenesulfonate) (PANI/PSS). These materials may be used alone or in combination of two or more thereof.

Likewise, the hole transport materials may also be selected from any known hole transport materials without limitation. Non-limiting examples of hole transport materials include: carbazole derivatives such as phenylcarbazole and polyvinylcarbazole; fluorene derivatives; triphenylamine derivatives such as N,N'-bis(3-methylphenyl)-N,N'-diphenyl-[1,1-biphenyl]-4,4'-diamine (TPD) and 4,4',4"-tris(N-carbazolyl)triphenylamine (TCTA); N,N'-di(1-naphthyl)-N,N'-diphenylbenzidine (NPB); and 4,4'-cyclohexylidene bis[N,N-bis(4-methylphenyl)benzenamine] (TAPC). These materials may be used alone or in combination of two or more thereof.

The hole transport region (30) may be manufactured using conventional methods known in the art. Examples include vacuum deposition, spin coating, casting, Langmuir-Blodgett (LB) method, inkjet printing, laser printing, and laser-induced thermal imaging (LITI), but are not limited thereto.

### Emission Layer

The emission layer (40) included in the organic layer (A) of the present disclosure is the layer where holes and electrons combine to form excitons, and the color of the light emitted by the organic electroluminescent element may vary depending on the material that constitutes the emission layer (40).

The emission layer (40) may include a host and a dopant, and the mixing ratio thereof can be appropriately adjusted within the range known in the field. For example, the emission layer (40) may include 70 to 99.9 parts by weight of a host and 0.1 to 30 parts by weight of a dopant, based on the total weight of the emission layer (40). More specifically, when the emission layer (40) is blue fluorescent, green fluorescent, or red fluorescent, it may include 80 to 99.9 parts by weight of a host and 0.1 to 20 parts by weight of a dopant. Additionally, when the emission layer (40) is blue fluorescent, green fluorescent, or red phosphorescent, it may include 70 to 99 parts by weight of a host and 1 to 30 parts by weight of a dopant.

The host included in the emission layer (40) of the present disclosure is not particularly limited as long as it is known in the industry. Non-limiting examples of the host include alkali metal complexes, alkaline earth metal complexes, and condensed aromatic ring derivatives.

More specifically, an aluminum complex, a beryllium complex, an anthracene derivative, a pyrene derivative, a triphenylene derivative, a carbazole derivative, a dibenzofuran derivative, a dibenzothiophene derivative, or a combination thereof, which can enhance the luminous efficiency and lifespan of the organic electroluminescent element, is preferably used as a host material.

The dopant included in the emission layer (40) of the present disclosure is also not particularly limited as long as it is known in the industry. Non-limiting examples of the dopant include anthracene derivatives, pyrene derivatives, arylamine derivatives, and metal complexes containing iridium (Ir) or platinum (Pt).

The dopant can be classified into red, green, and blue dopants. So long as it is known in the technical field, any red, green, and blue dopants may be used without particular limitation.

Specifically, non-limiting examples of red dopants include Pt(II) octaethylporphine (PtOEP), tris(2-phenylisoquinoline)iridium (Ir(piq)3), and bis(2-(2'-benzothienyl)-pyridinato-N,C3')iridium(acetylacetonate) (Btp2Ir(acac)), and mixtures of two or more thereof.

Non-limiting examples of green dopants include tris(2-phenylpyridine) iridium (Ir(ppy)3), bis(2-phenylpyridine) (acetylacetonato)iridium(III) (Ir(ppy)2(acac)), tris(2-(4-tolyl)phenylpiridine)iridium (Ir(mppy)3), 10-(2-benzothiazolyl)-1,1,7,7-tetramethyl-2,3,6,7-tetrahydro-1H,5H,11H-benzopyrano [6,7,8-ij]-quinolizin-11-one (CS45T), and mixtures of two or more thereof.

Non-limiting examples of blue dopants include bis3,5-difluoro-2-(2-pyridyl)phenyliridium(III) (F2Irpic), (F2ppy)2Ir(tmd), Ir(dfppz)3, 4,4'-bis(2,2'-diphenylethen-1-yl)biphenyl (DPVBi), 4,4'-bis[4-(diphenylamino)styryl]biphenyl (DPAVBi), 2,5,8,11-tetra-tert-butyl perylene (TBPe), and mixtures of two or more thereof.

The emission layer (40) of the present disclosure may be a red emission layer containing a red phosphorescent material, a green emission layer containing a green phosphorescent material, or a blue emission layer containing a blue phosphorescent or fluorescent material, with preference for an emission layer containing a blue fluorescent material.

The aforementioned emission layer (40) may be a single layer composed of one material, a single layer composed of multiple different materials, or a multi-layer structure including two or more layers different in component material from each other. In cases where the emission layer (40) is a multilayered structure, the organic electroluminescent element can emit light of various colors. Specifically, the present disclosure can provide an organic electroluminescent element including a plurality of emission layers that are arranged in series with difference in constituent material from one layer to another, whereby the organic electroluminescent element can emit mixed colors. Additionally, when including a plurality of emission layers, the organic electroluminescent element increases in driving voltage, but remains constant in current value, thus exhibiting improved luminous efficiency in proportion to the number of emission layers.

Although not shown in the figure, the organic electroluminescent element (100) may include a plurality of emission stacks (not shown), each containing at least one emission layer.

The multiple emission layers included in these emission stacks may either emit light of different colors or emit light of the same color. That is, the emission color may vary depending on the material constituting the emission layer. For example, the multiple emission stacks may include materials that emit blue, green, red, yellow, or white light and may be formed using phosphorescent or fluorescent materials. In this regard, the colors of the emission layers may be complementary to each other. Additionally, color combinations that emit white light can be selected. Each of these emission layers may contain phosphorescent or fluorescent dopants corresponding to the selected color.

Although not shown in the figure, the organic electroluminescent element (100) may further include a charge generation layer (not shown) disposed between adjacent emission stacks and connecting them.

The charge generation layer (CGL) refers to a layer in an organic electroluminescent element comprising multiple emission stacks, which separates adjacent emission stacks while not in direct contact with the two electrodes (e.g., anode and cathode). This charge generation layer is arranged between two adjacent emission stacks and acts as a cathode by generating electrons for one stack and as an anode by generating holes for the other stack. So long as it is known in the art, any material may be used for the charge generation layer without limitation. Additionally, the material for the charge generation layer may be doped with conventional n-type and/or p-type materials known in the field.

### Electron Transport Region

In the organic electroluminescent element (100) according to the present disclosure, the electron transport region (50) included in the organic layer (A) serves to transport electrons injected from the cathode (20) to the emission layer (40).

This electron transport region (50) may include an electron transport layer (51) having a multilayered structure including at least two layers, or the multilayered electron transport layer (51) and an electron injection layer (52). Optionally, the electron transport region may further include an electron transport auxiliary layer (not shown).

Conventional electron transport layers (51) might be formed of with the electron transport layer material together with lithium compounds such as Li, LiF, LiQ, etc. to improve electron injection characteristics. However, such lithium-doped electron transport layers contain metals, which are prone to oxidation over time, leading to a potential decrease in the lifespan of the organic electroluminescent element.

In the present disclosure, the electron transport layer is composed solely of organic compounds instead of lithium compounds, fundamentally addressing the issues of metal-containing electron transport layers. By adopting an organic material with high electron injection capability and configuring a multilayer structure for the electron transport layer, the organic electroluminescent element exhibits superior characteristics such as low voltage, high efficiency, and long lifespan compared to conventional organic electroluminescent elements with metal-containing electron transport layers.

Specifically, in the present disclosure, the electron transport layer (51) is configured to include at least two layers with no metals in any thereof, wherein a first layer (51a), composed of a single compound (e.g., first compound), is positioned adjacent to the emission layer (40) while a second layer (51b), composed of at least two organic compounds (e.g., second and third compounds), is positioned adjacent to the cathode (20).

Here, the single compound (i.e., first compound) constituting the first layer (51a) and one of the organic compounds (i.e., second and third compounds) constituting the second layer (51b) may be same or different.

In the electron transport layer (51) according to the present disclosure, the first layer (51a) is a single layer composed of an organic compound that has a stable structure for electron transport. The first layer (51a) blocks hole transport from the emission layer to increase the exciton density in the emission layer, thereby improving the device's efficiency. Additionally, the first layer plays a role in increasing mobility, allowing electrons transferred from the second layer (51b) to move quickly to the emission layer (40).

The first layer (51a) is composed of a specific single organic compound to enhance the performance of the element and may satisfy at least one of the properties described below to exhibit low driving voltage and high efficiency.

In an embodiment, the first layer (51a) may have a Highest Occupied Molecular Orbital (HOMO) energy level of 5.4 eV or higher, specifically between 5.4 and 6.5 eV, and more specifically between 5.4 and 6.3 eV. This HOMO energy level prevents holes transferred to the emission layer (40) from diffusing or moving into other electron transport regions, thereby increasing the probability of recombination between holes and electrons in the emission layer (40), which enhances the luminous efficiency of the organic electroluminescent element. Additionally, the HOMO energy level prevents the irreversible decomposition reactions caused by oxidation when holes diffuse or move beyond the emission layer (40) into other layers, thereby improving the lifespan of the organic electroluminescent element. In this context, the HOMO energy level refers to the absolute value of the HOMO.

In another embodiment, the first layer (51a) may have a bandgap energy (E_{bg}) of 2.7 eV or higher, specifically between 2.7 and 4.0 eV, and more specifically between 2.7 and 3.8 eV. Given the bandgap energy, the first layer (51a) allows for high-efficiency characteristics.

In another embodiment, the first layer (51a) may have a triplet energy (T1) of 1.5 eV or higher, specifically between 1.5 and 3.3 eV, and more specifically between 1.6 and 3.3 eV. The triplet energy value prevents excitons from moving to other layers, thereby significantly increasing the efficiency of the organic electroluminescent element.

In another embodiment, the first layer (51a) may have a singlet energy (S1) of 2.5 eV or higher, specifically between 2.5 and 3.5 eV, and more specifically between 2.7 and 3.5 eV. The singlet energy value effectively confines singlet excitons, preventing their diffusion to adjacent interfaces and/or other layers, and thereby increases the number of excitons, improving the luminous efficiency of the organic electroluminescent element. As a result, this prevents spectral color mixing and enhances the stability, further improving the efficiency and lifespan of the organic electroluminescent element.

In the electron transport layer (51) according to the present disclosure, the second layer (51b) is a single layer formed by mixing two or more specific organic materials (e.g., second and third compounds) with high electron injection ability, instead of using metals such as lithium compounds. Particularly in the present disclosure, the second layer (51b) is composed of a mixture of an organic material (e.g., second compound) that improves lifespan and an organic material (e.g., third compound) that improves efficiency, in a predetermined mixing ratio, thereby simultaneously enhancing both the efficiency and lifespan of the device.

The second layer (51b) includes an organic mixture of second and third compounds different from each other. The organic mixture may be co-deposited or formed using conventional methods known in the field.

In the second layer (51b) of the present disclosure, the mixing ratio of the second and third compounds is not particularly limited. For example, the second and third compounds may be mixed in a weight ratio of 50:50 to 90:10 based on the total weight of the second layer (51b). In the second layer (51b), the material with the higher content among the second and third compounds primarily performs the role of transporting electrons injected from the cathode (20) to the emission layer (40), while the material with the lower content can perform an auxiliary role in the electron transport layer.

The second layer (51b), composed of a predetermined organic mixture, can improve the performance of the device by excluding metals, and preferably satisfy at least one of the properties described below in order to exhibit low voltage, high efficiency, and long lifespan characteristics.

In an embodiment, the second layer (51b) may have a HOMO energy level higher than that of the first layer (51a) . For example, the HOMO energy level may be 5.6 eV or higher, specifically between 5.6 and 6.5 eV, and more specifically between 5.6 and 6.3 eV. Herein, the HOMO energy level refers to the absolute value of the HOMO.

In another embodiment, the bandgap energy of the second layer (51b) may be smaller than that of the first layer (51a). For example, the bandgap energy may be 2.5 eV or higher, specifically between 2.5 and 3.7 eV, and more specifically between 2.5 and 3.5 eV.

In another embodiment, the triplet energy of the second layer (51b) may be higher than that of the first layer (51a). For example, the triplet energy may be 1.7 eV or higher, specifically between 1.7 and 3.3 eV, and more specifically between 1.7 and 3.1 eV.

In another embodiment, the sum of bond moment vectors (D) in each of the first layer (51a) and the second layer (51b) may be 3.336 × 10⁻³¹C·m or higher. Herein, the sum of bond moment vectors (D) is obtained from the results of structural optimization calculations based on density functional theory (B3LYP/6-31G*) for the compounds constituting each layer (51a, 51b).

Specifically, the sum of bond moment vectors (D₂) in the second layer (51b), which is positioned at a certain distance from the emission layer (40), may be greater than the sum of bond moment vectors (D₁) in the first layer (51a), which is adjacent to the emission layer (40). Configured to have the sums of bond moment vectors (D), the first layer (51a) and the second layer (51b) can prevent excitons from being lost at the interface between the emission layer (40) and the electron transport layer (51), thereby improving the efficiency of the element. For example, the difference in the sum of bond moment vectors between the second layer (51b) and the first layer (51a) (D₂ - D₁) may be greater than zero.

Additionally, the first compound included in the first layer (51a) and the second and third compounds included in the second layer (51b) can facilitate smooth electron transfer from the cathode to the electron transport layers (the second layer and the first layer) and the emission layer if they share similar moieties. Therefore, it is necessary for the materials included in the first layer (51a) and the second layer (51b) to have similar moieties and the sum of bond moment vectors (D) within the aforementioned numerical ranges. Detailed descriptions of the moieties of the first to third compounds constituting the electron transport layer (51) will be provided below.

In the at least two-layer electron transport layer (51) according to the present disclosure, the first compound constituting the first layer (51a) and one of the second and third compounds constituting the second layer (51b) may be same, or all of them may be different from each other.

In an embodiment, if the first compound constituting the first layer (51a) and the second and third compounds constituting the second layer (51b) are all different, the sum of bond moment vectors (D2) in either the second compound or the third compound constituting the second layer (51b) may be greater than the sum of bond moment vectors (D1) in the first compound, but with no limitations thereto.

In another embodiment, one of the second and third compounds constituting the second layer (51b) may be same as the first compound included in the first layer (51a), while the other may be a different substance from the first compound.

In a specific embodiment, the sum of bond moment vectors (D₂) in either the second or the third compound different from the first compound may be greater than the sum of bond moment vectors (D₁) in the first compound of the first layer (51a). Additionally, the content of one of the second and third compounds, which is different from the first compound, may be greater than that of the other compound that is same as the first compound.

When satisfying the configurations, parameters, and/or numerical values described above, the first layer (51a) and second layer (51b) constituting the electron transport layer of the present disclosure are not particularly limited in terms of the detailed composition of the compounds constituting the electron transport layer (51), such as the type of moieties included in the compound (e.g., EDG group, EWG group), their bonding positions, the introduction positions of linkers and compositions thereof, etc.

In a specific embodiment, the first compound constituting the first layer (51a) and the second and third compounds constituting the second layer (51b) may each be a bipolar compound that simultaneously includes an electron-withdrawing moiety (EWG) with high electron affinity and an electron-donating moiety (EDG) with high electron-donating properties.

More specifically, the first to third compounds (materials) may each include at least one electron-withdrawing moiety (EWG) selected from six-membered moieties, five-membered moieties, and polycyclic moieties formed by condensation of the six-membered and five-membered moieties, which are described below.

For example, each of the first to third compounds may include at least one first moiety represented by the following chemical formulas: 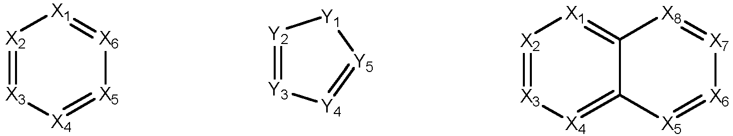 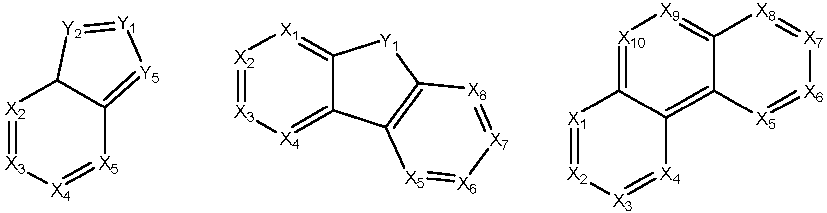 wherein,
X₁ to X₁₀ and Y₁ to Y₅, which are same or different from each other, may each be independently N or C(R), with a proviso that the single or fused ring moiety comprises at least one N;
if there are multiple C(R) groups, the multiple R radicals, which are same or different, may each be independently selected from the group consisting of a hydrogen atom, a deuterium atom, a halogen group, a cyano group, a nitro group, an amino group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 nuclear atoms, a C₆-C₆₀ aryl group, a heteroaryl group having 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₆-C₆₀ arylphosphine group, a C₆-C₆₀ arylphosphine oxide group, and a C₆-C₆₀ arylamine group, or may bond with adjacent groups to form fused rings, and
the alkyl group, alkenyl group, alkynyl group, aryl group, heteroaryl group, aryloxy group, alkoxy group, cycloalkyl group, heterocycloalkyl group, arylamine group, alkylsilyl group, alkylboron group, arylboron group, arylphosphine group, arylphosphine oxide group, and arylamine group in R each are independently substituted with one or more substituents selected from the group consisting of a hydrogen atom, a deuterium atom (D), a halogen, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 nuclear atoms, a C₆-C₆₀ aryl group, a heteroaryl group having 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₆-C₆₀ arylphosphine group, a C₆-C₆₀ arylphosphine oxide group, and a C₆-C₆₀ arylamine group, and when the substituents are plural in number, the substituents are the same as or different from each other.

The first to third compounds (materials) each include at least one heteroaromatic ring containing at least one nitrogen (N) in the molecular structure thereof, that is, an electron-withdrawing group (EWG), thereby exhibiting excellent electronic properties. Accordingly, when used as a material for the multilayer electron transport layer (51), a compound with a six-membered moiety, a five-membered moiety, or a fused polycyclic moiety thereof can effectively accept electrons from the cathode (20) and smoothly transfer same to the emission layer (40), lowering the driving voltage of the element (100) and leading to high efficiency and long lifespan.

Additionally, the materials for the electron transport layer (51) not only have high triplet energy but also can significantly increase the molecular weight of the compounds by adjusting the types and introduction positions of various substituents on the framework, resulting in enhanced glass transition temperature and high thermal stability. Furthermore, these materials are effective in suppressing crystallization in the organic layer, thereby significantly improving the durability and lifespan characteristics of the organic electroluminescent element (100).

According to an embodiment of the present disclosure, the electron-withdrawing group (EWG) moieties in the first to third compounds constituting the electron transport layer (51) may be more specifically defined as any one selected from the group of the following structural formulas, but with no limitations thereto: 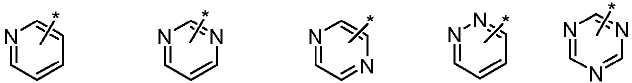 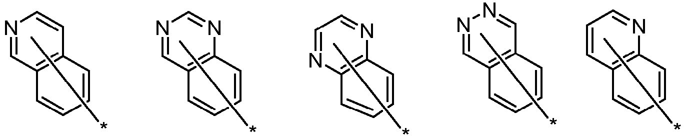 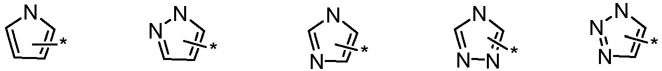 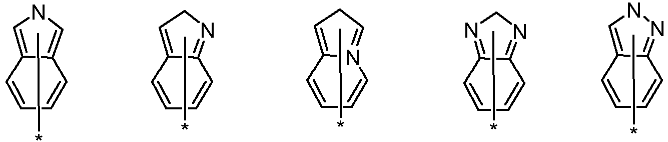 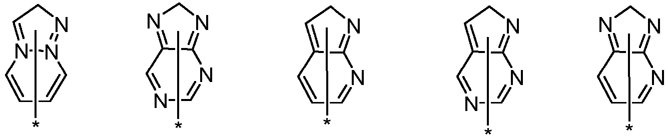 wherein,
* represents a site where a bond is made to any one of the first to third compound.

Although not explicitly shown in the structural formulas, one or more substituents known in the field (e.g., same as those defined as R) may be given. Furthermore, while only one bonding site (*) to a compound forming the exciton confinement layer is shown in the structural formulas, cases where two bonding sites are included also fall within the scope of the present disclosure.

In an embodiment of the present disclosure, the first to third compounds constituting the at least two-layer structured electron transport layer (51) may include at least one electron-donating moiety (EDG) known in the field, which is different from the aforementioned electron-withdrawing group (EWG) and has higher electron-donating properties than the EWG.

For example, the first to third compounds may each include at least one second moiety (e.g., EDG) represented by one of the following chemical formulas: 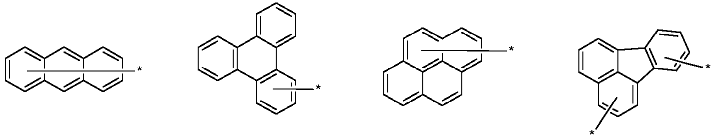 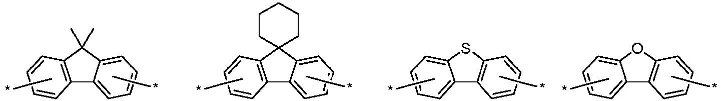 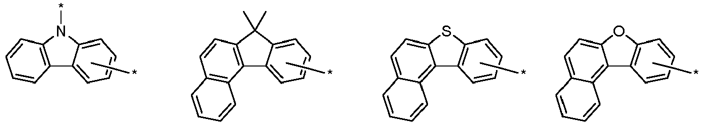 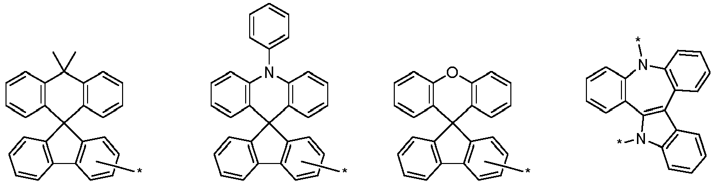 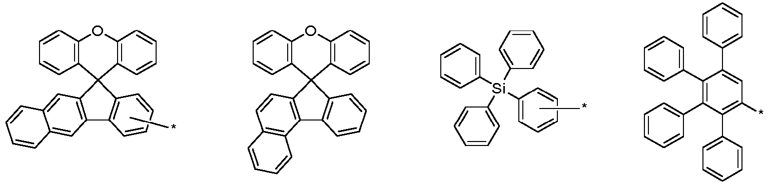 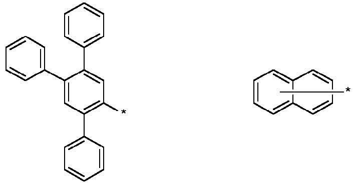 wherein,
* represents a site where a bond is made to any one of the first to third compounds.

Although not explicitly shown in the structural formulas, one or more substituents known in the field (e.g., same as those defined as R) may be given to the structural formulas. Furthermore, while only one bonding site (*) to at least one of the first to third compounds is shown in the structural formulas, cases where two bonding sites are included also fall within the scope of the present disclosure.

The compounds available as materials for the electron transport layer (51) of the present disclosure, as described above, can be more specifically defined by the example compounds mentioned below. However, the first to third compounds of the present disclosure are not limited to the examples listed. Specifically, as long as satisfying the composition and/or properties of the electron transport layer, the moieties (e.g., EDG, EWG) included in the compound are not particularly limited in view of types, bonding positions, and the introduction positions of linkers, and compounds with various chemical structure modifications also fall within the scope of the present disclosure.

The electron transport layer (51) of the present disclosure may be formed using methods known in the field, such as vacuum deposition, spin coating, casting, Langmuir-Blodgett (LB) method, inkjet printing, laser printing, laser-induced thermal imaging (LITI), and the like, but with no limitations thereto.

In the electron transport region (50) of the present disclosure, the electron injection layer (52) may use any electron injection material that facilitates electron injection and has high electron mobility without limitation. Non-limiting examples of usable electron injection materials include bipolar compounds, anthracene derivatives, heteroaromatic compounds, and alkali metal complexes. Specifically, examples include: LiF, Li2O, BaO, NaCl, and CsF; lanthanide metals such as Yb; or metal halides such as RbCl and RbI, which may be used alone or in a mixture of two or more thereof.

The electron transport region (50) according to the present disclosure, specifically the electron injection layer (52), may also be co-deposited with an n-type dopant to facilitate electron injection from the cathode. In this regard, the n-type dopant may be any alkali metal complex known in the field, such as alkali metals, alkaline earth metals, or rare earth metals.

The electron transport region (50) may be manufactured using conventional methods known in the field. Examples include vacuum deposition, spin coating, casting, Langmuir-Blodgett (LB) method, inkjet printing, laser printing, and laser-induced thermal imaging (LITI), but is not limited to these.

### Light-Emitting Auxiliary Layer

Optionally, the organic electroluminescent element (100) of the present disclosure may further include a light-emitting auxiliary layer (not shown) disposed between the hole transport region (30) and the emission layer (40).

The light-emitting auxiliary layer plays a role in transporting holes from the hole transport region (30) to the emission layer (40) while also adjusting the thickness of the organic layer (A). This light-emitting auxiliary layer has a high LUMO value, which prevents electrons from moving into the hole transport layer (32), and a high triplet energy, which prevents excitons in the emission layer (40) from diffusing into the hole transport layer (32).

This light-emitting auxiliary layer may include a hole transport material and may be made of the same material as the hole transport region. Additionally, the light-emitting auxiliary layer of red, green, and blue organic electroluminescent elements may be made of the same material.

The light-emitting auxiliary layer material is not particularly limited and may include, for example, carbazole derivatives or arylamine derivatives. Non-limiting examples of usable light-emitting auxiliary layer materials include N, N-dinaphthyl-N, N'-diphenyl benzidine (NPD), N, N'-bis-(3-methylphenyl)-N, N'-bis(phenyl)-benzidine (TPD), s-TAD, and 4,4',4"-Tris(N-3-methylphenyl-N-phenyl-amino)-triphenylamine (MTDATA). These materials can be used alone or in combination of two or more. Furthermore, the light-emitting auxiliary layer may include a p-type dopant in addition to the aforementioned materials. The p-type dopant may be any known p-type dopant used in the field.

### Capping Layer

Optionally, the organic electroluminescent element (100) of the present disclosure may further include a capping layer (not shown) disposed on the aforementioned cathode (20). The capping layer serves to protect the organic electroluminescent element and helps ensure that light generated in the organic layer is efficiently emitted to the outside.

The capping layer may include at least one selected from the group consisting of tris-8-hydroxyquinoline aluminum (Alq3), ZnSe, 2,5-bis(6'-(2',2"-bipyridyl))-1,1-dimethyl-3,4-diphenylsilole, 4'-bis[N-(1-naphthyl)-N-phenyl-amino] biphenyl (α-NPD), N,N'-diphenyl-N,N'-bis(3-methylphenyl)-1,1'-biphenyl-4,4'-diamine (TPD), and 1,1'-bis(di-4-tolylaminophenyl) cyclohexane (TAPC). The materials that form the capping layer are cheaper compared to the materials used in other layers of the organic electroluminescent element.

The capping layer may be a single layer or may consist of two or more layers with different refractive indices, allowing the light to undergo a gradual change in refractive index as the light passes through these layers.

The capping layer may be formed using conventional methods known in the art, such as vacuum deposition, spin coating, casting, or Langmuir-Blodgett (LB) methods.

The organic electroluminescent element of the present disclosure, which includes the aforementioned configuration, can be manufactured by conventional methods known in the field. For example, an organic electroluminescent element can be manufactured by vacuum depositing an anode material on a substrate, followed by sequential vacuum deposition of the hole transport region material, emission layer material, electron transport region material, and cathode material.

The organic electroluminescent element (100, 200) of the present disclosure has a structure in which the anode (10), organic layer (A), and cathode (20) are sequentially stacked, but may further include an insulating layer or an adhesive layer between the anode (10) and the organic layer (A) or between the cathode (20) and the organic layer (A). The organic electroluminescent element of the present disclosure can exhibit excellent lifespan characteristics because the half-life of the initial brightness (life time) increases while maintaining maximum luminous efficiency when voltage, current, or both are applied.

A better understanding of the present disclosure will be obtained through the following examples, which are set forth to illustrate, but are not to be construed to limit, the present disclosure.

### [PREPARATION EXAMPLE] Compounds 1 to 30

The compounds according to the present disclosure were prepared as described below, and the sum of their bond moment vectors, HOMO, triplet energy, and singlet energy were each measured by methods known in the art and are summarized in Table 1 below.

HOMO refers to an energy level measured by cyclic voltammetry (CV) method, which determines the energy level from the relative potential value with respect to a reference electrode with a known electrode potential. For example, the HOMO energy level of a material can be measured using Ferrocene, which has known oxidation and reduction potentials, as a reference electrode.

The sum of bond moment vectors, HOMO energy, triplet energy, and singlet energy were each calculated using the Gaussian program with the B3LYP/6-31G* calculation method.

**[TABLE 1]**

| Cpd. | HOMO (eV) | Band Gap (eV) | Sum of bond moment vector (C·m) | Triplet energy (T₁, eV) | Singlet energy (S₁, eV) |
|---|---|---|---|---|---|
| 1 | 5.42 | 2.80 | 3.27 × 10-30 | 2.46 | 2.94 |
| 2 | 6.08 | 3.59 | 3.74 × 10-30 | 2.34 | 3.10 |
| 3 | 6.23 | 3.78 | 1.93 × 10⁻³⁰ | 2.31 | 3.09 |
| 4 | 5.82 | 3.65 | 3.04 × 10-30 | 2.54 | 2.90 |
| 5 | 6.02 | 3.60 | 2.54 × 10⁻³⁰ | 2.53 | 3.00 |
| 6 | 6.20 | 3.64 | 6.41 × 10⁻³⁰ | 2.35 | 2.93 |
| 7 | 5.73 | 3.50 | 3.90 × 10⁻³⁰ | 2.52 | 2.89 |
| 8 | 6.06 | 3.35 | 9.34 × 10⁻³⁰ | 2.46 | 3.01 |
| 9 | 5.93 | 3.70 | 7.11 × 10⁻³⁰ | 2.43 | 2.97 |
| 10 | 5.59 | 3.29 | 8.67 × 10⁻³⁰ | 2.39 | 3.09 |
| 11 | 5.57 | 3.60 | 7.11 × 10⁻³⁰ | 2.44 | 3.20 |
| 12 | 6.00 | 3.57 | 2.70 × 10-30 | 2.53 | 3.15 |
| 13 | 6.29 | 3.71 | 3.04 × 10-30 | 2.70 | 3.22 |
| 14 | 5.98 | 3.37 | 2.87 × 10-30 | 2.39 | 3.21 |
| 15 | 5.88 | 3.21 | 6.27 × 10-30 | 2.49 | 3.10 |
| 16 | 5.96 | 3.62 | 3.34 × 10-30 | 2.41 | 3.21 |
| 17 | 6.12 | 3.57 | 9.94 × 10⁻³⁰ | 2.45 | 3.06 |
| 18 | 5.93 | 3.45 | 5.57 × 10-30 | 2.31 | 3.27 |
| 19 | 6.25 | 3.60 | 7.01 × 10⁻³⁰ | 2.54 | 3.25 |
| 20 | 5.98 | 3.27 | 1.38 × 10⁻²⁹ | 2.49 | 3.11 |
| 21 | 6.46 | 3.70 | 1.17 × 10⁻²⁹ | 2.41 | 3.06 |
| 22 | 5.86 | 3.37 | 6.24 × 10-30 | 2,31 | 3.14 |
| 23 | 5.90 | 3.75 | 4.10 × 10⁻³⁰ | 2.55 | 3.24 |
| 24 | 5.91 | 3.30 | 1.37 × 10⁻²⁹ | 2.49 | 3.29 |
| 25 | 6.01 | 3.27 | 4.74 × 10-30 | 2.39 | 3.16 |
| 26 | 6.21 | 3.47 | 1.44 × 10⁻²⁹ | 2.31 | 3.11 |
| 27 | 6.05 | 3.20 | 3.37 × 10-30 | 2.39 | 3.00 |
| 28 | 5.76 | 3.34 | 7.27 × 10-30 | 2.63 | 2.06 |
| 29 | 5.74 | 3.03 | 3.17 × 10-30 | 2.30 | 2.87 |
| 30 | 6.04 | 3.41 | 7.17 × 10-30 | 2.33 | 3.06 |

The structures of each compound 1 to 30 used in Table 1 are shown below.

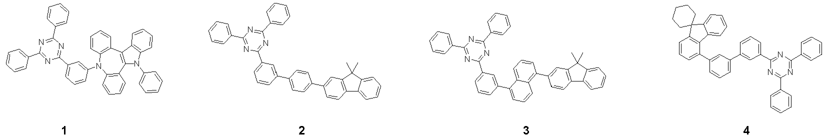

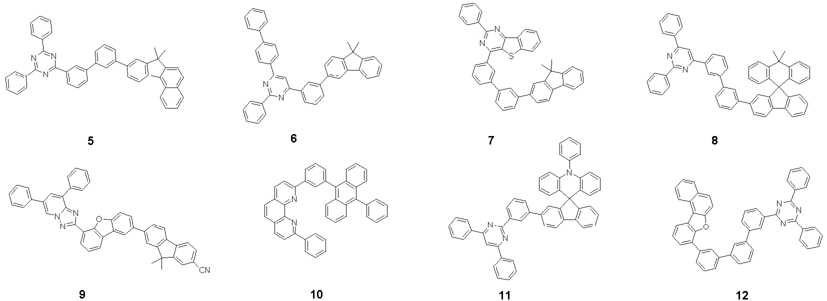

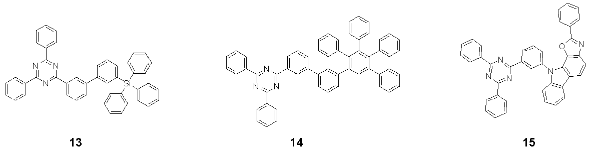

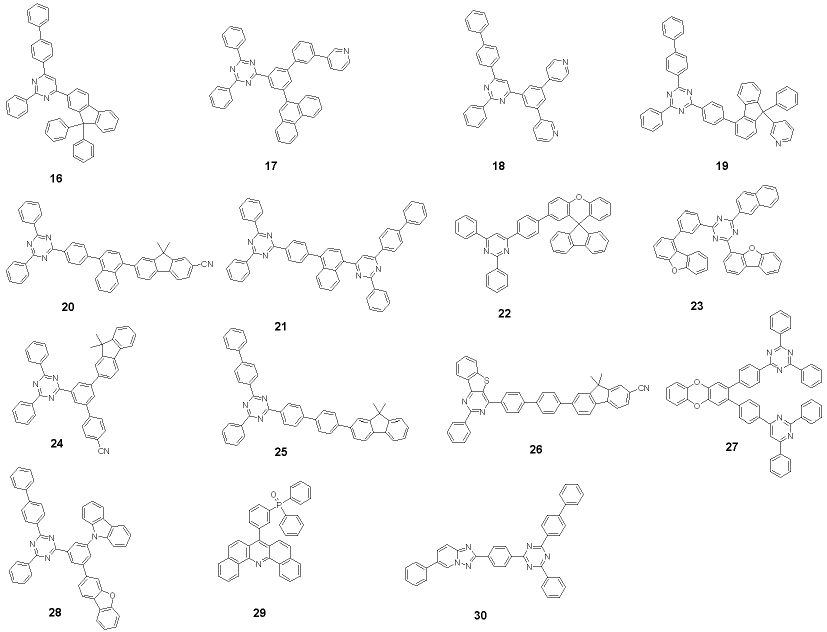

### EXAMPLES 1-15] Fabrication of Blue Organic EL Elements

After purifying compounds 1 to 15 through high-purity sublimation using methods known in the art, blue organic EL elements were prepared according to the following process.

First, a glass substrate with an indium tin oxide (ITO) thin film coating of 1500 Å thickness was cleansed by ultrasonication with distilled water. After cleansing with distilled water, ultrasonic cleansing was performed with solvents such as isopropyl alcohol, acetone, and methanol. The substrate was dried and then transferred to a UV ozone cleaner (Power Sonic 405, Hwashin Tech), where the substrate was cleaned with UV for 5 minutes before being transferred to a vacuum deposition machine.

On the prepared ITO transparent electrode, organic electroluminescent elements were fabricated by sequentially depositing DS-205 (Doosan Electronics, 80 nm)/NPB (15 nm)/ADN + 5% DS-405 (Doosan Electronics, 30 nm)/the compounds of Table 3 (first layer: 5 nm, second layer: 25 nm)/LiF (1 nm)/Al (200 nm) (see Table 2 below).

**[TABLE 2]**

| | Compound | Thickness (nm) |
|---|---|---|
| Hole injection layer | DS-205 | 80 |
| Hole transport layer | NPB | 15 |
| Emission layer | ADN + 5% DS-405 | 30 |
| Electron transport layer (1^{st} layer) | Compounds 1-15 | 5 |
| Electron transport layer (2^{nd} layer) | Compounds 16-30 + Compounds 16-30 | 25 |
| Electron injection layer | LiF | 1 |
| Cathode | Al | 200 |

### [COMPARATIVE EXAMPLE 1] Fabrication of Blue Organic EL Element

A blue organic electroluminescent element for Comparative Example 1 was fabrication in the same manner as in Example 1, with the exception that Alq₃ was used solely as the second compound of the second layer, without using the first or third compounds.

### [COMPARATIVE EXAMPLE 2] Fabrication of Blue Organic EL Element

A blue organic electroluminescent element for Comparative Example 2 was fabrication in the same manner as in Example 1, with the exception that Alq₃ and LiQ were used as the second and the third compound constituting the second layer, respectively, without using the first compound.

### [COMPARATIVE EXAMPLE 3] Fabrication of Blue Organic EL Element

A blue organic electroluminescent element for Comparative Example 3 was fabrication in the same manner as in Example 1, with the exception that compounds 16 and 17 were used as the second and the third compound constituting the second layer, respectively, without using the first compound.

### [COMPARATIVE EXAMPLE 4] Fabrication of Blue Organic EL Element

A blue organic electroluminescent element for Comparative Example 4 was fabrication in the same manner as in Example 1, with the exception that the first compound was not used.

### [COMPARATIVE EXAMPLE 5] Fabrication of Blue Organic EL Element

A blue organic electroluminescent element for Comparative Example 5 was fabrication in the same manner as in Example 1, with the exception that Alq₃ was used, instead of compound 16, as the second compound constituting the second layer and the third compound was not contained.

### [COMPARATIVE EXAMPLE 6] Fabrication of Blue Organic EL Element

A blue organic electroluminescent element for Comparative Example 6 was fabrication in the same manner as in Example 1, with the exception that Alq₃ and LiQ were used as the second and the third compound constituting the second layer, respectively.

### [EVALUATION EXAMPLE 1]

The blue EL elements fabricated in Examples 1-15 and Comparative Examples 1-6 were measured for driving voltage, current efficiency, and emission peak at a current density of 10 mA/cm², and the results are summarized in Table 3 below.

**[TABLE 3]**

| Sample | 1^{st} Layer | 2^{nd} Layer | | | Driving Volt. (V) | EL Peak (nm) | Current efficiency (cd/A) |
|---|---|---|---|---|---|---|---|
| | 1^{st} Cpd. | 2^{nd} Cpd. | 3^{rd} Cpd. | Mixing ratio | | | |
| Ex. 1 | 1 | 16 | 17 | 5:5 | 3.9 | 457 | 8.0 |
| Ex. 2 | 2 | 17 | 28 | 5:5 | 4.1 | 455 | 8.0 |
| Ex. 3 | 3 | 18 | 23 | 5:5 | 4.2 | 455 | 7.8 |
| Ex. 4 | 4 | 19 | 29 | 5:5 | 4.1 | 457 | 8.1 |
| Ex. 5 | 5 | 20 | 26 | 5:5 | 4.2 | 456 | 7.9 |
| Ex. 6 | 6 | 21 | 19 | 6:4 | 3.9 | 457 | 8.0 |
| Ex. 7 | 7 | 22 | 28 | 6:4 | 4.0 | 456 | 7.8 |
| Ex. 8 | 8 | 23 | 28 | 3:7 | 4.1 | 456 | 8.1 |
| Ex. 9 | 9 | 24 | 23 | 3:7 | 4.0 | 456 | 7.9 |
| Ex. 10 | 10 | 25 | 16 | 1:9 | 4.2 | 458 | 8.1 |
| Ex. 11 | 11 | 26 | 24 | 1:9 | 4.0 | 454 | 7.9 |
| Ex. 12 | 12 | 27 | 18 | 9:1 | 3.9 | 454 | 8.1 |
| Ex. 13 | 13 | 28 | 20 | 9:1 | 4.3 | 455 | 7.8 |
| Ex. 14 | 14 | 29 | 30 | 4:6 | 4.0 | 455 | 8.0 |
| Ex. 15 | 15 | 30 | 17 | 4:6 | 4.2 | 457 | 8.1 |
| C. Ex. 1 | - | Alq₃ | - | | 4.8 | 458 | 6.0 |
| C. Ex. 2 | - | Alq₃ | LiQ | 5:5 | 4.8 | 457 | 6.3 |
| C. Ex. 3 | - | 16 | - | | 4.6 | 457 | 6.5 |
| C. Ex. 4 | - | 16 | 17 | 5:5 | 4.6 | 458 | 6.6 |
| C. Ex. 5 | 1 | Alq₃ | - | | 4.6 | 458 | 6.9 |
| C. Ex. 6 | 1 | Alq₃ | LiQ | 5:5 | 4.5 | 457 | 7.2 |
| C. Ex. 7 | 1 | 16 | - | | 4.7 | 457 | 6.4 |
| C. Ex. 8 | 1 | 16 | Alq₃ | 5:5 | 4.5 | 458 | 7.4 |

As shown in Table 3, the blue organic electroluminescent elements of the present disclosure, which each include an electron transport layer provided with two layers including a first layer and a second layer which contain a single compound (e.g., compounds 1-15) and a mixture of two compounds (e.g., compounds 16-30), respectively, exhibits superior performance in terms of driving voltage and current efficiency compared to the controls that do not include these layers. Specifically, among the elements of Comparative Examples 1 to 4, which do not include the first layer, the elements with an electron transport layer composed of organic compounds (Comparative Examples 3-4) showed improved driving voltage and efficiency compared to those with metal-containing electron transport layers (Comparative Examples 1-2).

Furthermore, Comparative Examples 5 and 6, which each include a bilayer electron transport layer, showed improved driving voltage and efficiency compared to Comparative Examples 1 and 2, which each have a single-layer electron transport layer.

Additionally, Comparative Examples 7 and 8 that each include a bilayer electron transport layer composed of a first layer and a second layer, wherein the first and second layers are each made of a single organic compound for Comparative Example 7 and the first layer is made of a single organic compound and the second layer is made of a single organic compound and a metal, demonstrated performance equal to or greater than that of Comparative Examples 1 and 2, which have a single-layer electron transport layer, in terms of driving voltage and efficiency.

### [EXAMPLES 16-30] Fabrication of Blue Organic EL Elements

After purifying compounds 1 to 15 through high-purity sublimation using methods known in the art, blue organic EL elements were fabricated according to the following process.

First, a glass substrate with an indium tin oxide (ITO) thin film coating of 1500 Å thickness was cleansed by ultrasonication with distilled water. After cleansing with distilled water, ultrasonic cleansing was performed with solvents such as isopropyl alcohol, acetone, and methanol. The substrate was dried and then transferred to a UV ozone cleaner (Power Sonic 405, Hwashin Tech), where the substrate was cleaned with UV for 5 minutes before being transferred to a vacuum deposition machine.

On the prepared ITO transparent electrode, an organic electroluminescent element was fabricated by sequentially depositing DS-205 (Doosan Electronics, 80 nm)/NPB (15 nm)/ADN + 5% DS-405 (Doosan Electronics, 30 nm)/the compounds of Table 5 (first layer: 5 nm, second layer: 25 nm)/LiF (1 nm)/Al (200 nm) (see Table 4 below).

**TABLE 4**

| | Compound | Thickness (nm) |
|---|---|---|
| Hole injection layer | DS-205 | 80 |
| Hole transport layer | NPB | 15 |
| Emission layer | ADN + 5% DS-405 | 30 |
| Electron transport layer (1^{st} layer) | Compounds 1-15 | 5 |
| Electron transport layer (2^{nd} layer) | Compounds 16-30 + Compounds 1-15 | 25 |
| Electron injection layer | LiF | 1 |
| Cathode | Al | 200 |

### [EVALUATION EXAMPLE 2]

The blue EL elements fabricated in Examples 16-30 and Comparative Example 7 were measured for driving voltage, current efficiency, and emission peak at a current density of 10 mA/cm², and the results are summarized in Table 5 below.

**TABLE 5**

| Sample | 1^{st} layer | 2^{nd} layer | | | Driving | EL | Current |
|---|---|---|---|---|---|---|---|
| | 1^{st} Cpd. | 2^{nd} Cpd. | 3^{rd} Cpd. | Mixing ratio | volt. (V) | Peak (nm) | efficiency (cd/A) |
| Ex. 16 | 1 | 16 | 1 | 5:5 | 4.1 | 455 | 8.1 |
| Ex. 17 | 2 | 17 | 2 | 5:5 | 4.1 | 455 | 7.8 |
| Ex. 18 | 3 | 18 | 3 | 6:4 | 3.9 | 455 | 7.8 |
| Ex. 19 | 4 | 19 | 4 | 6:4 | 4.0 | 457 | 7.9 |
| Ex. 20 | 5 | 20 | 5 | 7:3 | 4.0 | 457 | 7.8 |
| Ex. 21 | 6 | 21 | 6 | 7:3 | 3.9 | 456 | 8.0 |
| Ex. 22 | 7 | 22 | 7 | 8:2 | 4.2 | 456 | 8.0 |
| Ex. 23 | 8 | 23 | 8 | 8:2 | 4.1 | 454 | 8.1 |
| Ex. 24 | 9 | 24 | 9 | 9:1 | 4.1 | 456 | 8.0 |
| Ex. 25 | 10 | 25 | 10 | 9:1 | 4.1 | 458 | 7.9 |
| Ex. 26 | 11 | 26 | 11 | 1:9 | 4.0 | 454 | 7.8 |
| Ex. 27 | 12 | 27 | 12 | 1:9 | 4.2 | 455 | 7.7 |
| Ex. 28 | 13 | 28 | 13 | 3:7 | 4.2 | 454 | 7.8 |
| Ex. 29 | 14 | 29 | 14 | 3:7 | 3.9 | 455 | 8.1 |
| Ex. 30 | 15 | 30 | 15 | 5:5 | 3.9 | 458 | 7.9 |
| C. Ex. 5 | 1 | Alq₃ | - | - | 4.6 | 458 | 6.9 |
| C. Ex. 9 | 1 | 30 | - | - | 4.7 | 456 | 6.5 |
| C. Ex. 10 | 1 | 30 | Alq₃ | 5:5 | 4.4 | 458 | 7.2 |

As shown in Table 5, the blue organic electroluminescent elements of the present disclosure, which each include an electron transport layer provided with two layers including a first layer and a second layer which contain a single compound (e.g., compounds 1-15) and a mixture of two compounds (e.g., compounds 1-30), respectively, exhibits superior performance in terms of driving voltage and current efficiency compared to the controls that do not include these layers. Specifically, even when the single organic material from the first layer was used as part of the mixture in the second layer, the elements demonstrated excellent performance in terms of driving voltage and current efficiency characteristics.

## Claims

1. An organic electroluminescent element, comprising:
an anode;
a cathode disposed facing the anode;
an emission layer disposed between the anode and cathode; and
an electron transport layer disposed between the emission layer and the cathode and provided with at least two layers including a first layer and a second layer,
wherein the first layer is adjacent with the emission layer and is composed of a first compound, and
the second layer is adjacent to the cathode and is composed of at least two organic compounds including a second compound and a third compound, one of which is identical to or different from the first compound.

2. The organic electroluminescent element of claim 1, wherein the electron transport layer provided with at least two layers does not any metals.

3. The organic electroluminescent element of claim 1, wherein the first layer has a HOMO energy level of 5.4 eV or higher.

4. The organic electroluminescent element of claim 1, wherein the first layer has a bandgap energy of 2.7 eV or higher.

5. The organic electroluminescent element of claim 1, wherein the first layer has a triplet energy of 1.5 eV or higher.

6. The organic electroluminescent element of claim 1, wherein the first layer has a singlet energy of 2.5 eV or higher.

7. The organic electroluminescent element of claim 1, wherein the second layer has a HOMO energy level of 5.6 eV or higher.

8. The organic electroluminescent element of claim 1, wherein the second layer has a bandgap energy of 2.5 eV or higher.

9. The organic electroluminescent element of claim 1, wherein the second layer has a triplet energy of 1.7 eV or higher.

10. The organic electroluminescent element of claim 1, wherein the first and second layers may each have a sum of bond moment vectors of 3.336 × 10⁻³¹ C·m or higher.

11. The organic electroluminescent element of claim 1, wherein the second layer is formed by co-deposition of the second and third compounds, and the first, second and third compounds are different from each other.

12. The organic electroluminescent element of claim 11, wherein the sum of bond moment vectors (D₂) in any one of the second and third compounds in the second layer is larger than the sum of bond moment vectors (D₁) in the first compound.

13. The organic electroluminescent element of claim 1, wherein the second layer is formed by co-deposition of the second and third compounds and any one of the second and third compounds are same as the first compound while other one is a different material from the first compound.

14. The organic electroluminescent element of claim 13, wherein the sum of bond moment vectors (D₂) in one of the second and third compounds which differs from the first compound is larger than the sum of bond moment vectors (D₁) in the first compound.

15. The organic electroluminescent element of claim 13, wherein one of the second and third compounds, which differs from the first compound, is used at a content greater than that of other one that is same as the first compound.

16. The organic electroluminescent element of claim 1, wherein the second and third compounds are mixed at a weight ratio of 50:50 to 90:10, based on the total weight of the second layer.

17. The organic electroluminescent element of claim 1, wherein each of the first to third compounds that constitute the first and second layers includes at least one first moiety represented by the following chemical formulas: 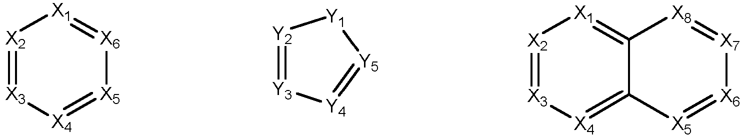 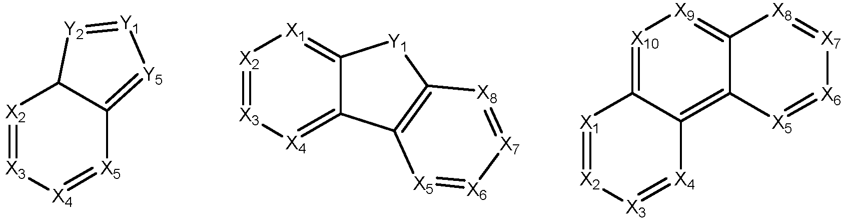
wherein in the Chemical Formula 1 or 2,
X₁ to X₁₀ and Y₁ to Y₅, which are same or different from each other, are each independently N or C(R), with a proviso that the single or fused ring moiety comprises at least one N;
when there are multiple C(R) groups, the multiple R radicals, which are same or different, are each independently selected from the group consisting of a hydrogen atom, a deuterium atom, a halogen group, a cyano group, a nitro group, an amino group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 nuclear atoms, a C₆-C₆₀ aryl group, a heteroaryl group having 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₆-C₆₀ arylphosphine group, a C₆-C₆₀ arylphosphine oxide group, and a C₆-C₆₀ arylamine group, or may bond with adjacent groups to form fused rings, and
the alkyl group, alkenyl group, alkynyl group, aryl group, heteroaryl group, aryloxy group, alkoxy group, cycloalkyl group, heterocycloalkyl group, arylamine group, alkylsilyl group, alkylboron group, arylboron group, arylphosphine group, arylphosphine oxide group, and arylamine group in R each are independently substituted with one or more substituents selected from the group consisting of a hydrogen atom, a deuterium atom (D), a halogen, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 nuclear atoms, a C₆-C₆₀ aryl group, a heteroaryl group having 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₆-C₆₀ arylphosphine group, a C₆-C₆₀ arylphosphine oxide group, and a C₆-C₆₀ arylamine group, and when the substituents are plural in number, the substituents are the same as or different from each other.

18. The organic electroluminescent element of claim 1, wherein the first to third compounds constituting the first and second layers each comprise at least one second moiety represented by any one of the following chemical formulas:

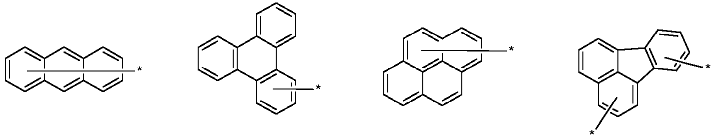

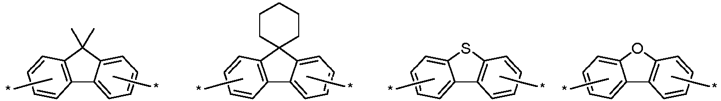

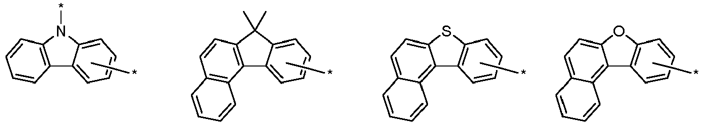

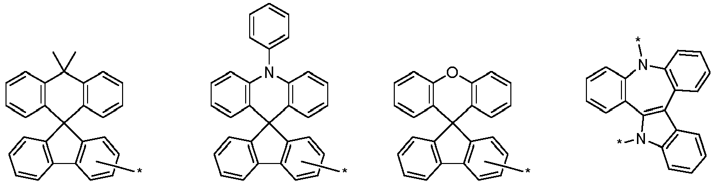

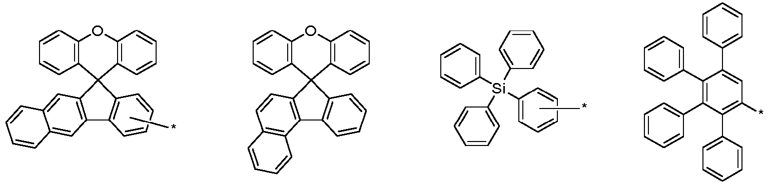

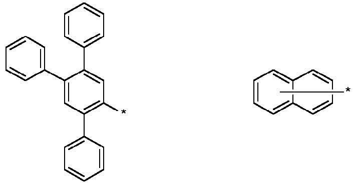

19. The organic electroluminescent element of claim 1, wherein the organic electroluminescent element comprises a hole transport region disposed between the anode and the emission layer, the hole transport region including at least one of a hole injection layer and a hole transport layer.

20. The organic electroluminescent element of claim 1, wherein the organic electroluminescent element comprises a plurality of emission layer stacks including at least one emission layer.
